# EUROPEAN PATENT APPLICATION

(11) **EP 4 845 327 A1**
(43) Date of publication of application: **25.11.2026**
(21) Application number: 24919770.8
(22) Date of filing: 27.09.2024
(51) Int. Cl.: H10B 12/00

(54) **STORAGE ARRAY AND PREPARATION METHOD THEREFOR, MEMORY, AND ELECTRONIC DEVICE**

(30) Priority: 25.01.2024 CN 202410110956
(71) Applicant: Huawei Technologies Co., Ltd., Shenzhen, Guangdong 518129 (CN)
(72) Inventor: GU, Junxing, Shenzhen, Guangdong 518129 (CN); LV, Hangbing, Shenzhen, Guangdong 518129 (CN); XU, Shengqiang, Shenzhen, Guangdong 518129 (CN); XU, Yannan, Shenzhen, Guangdong 518129 (CN); WANG, Chao, Shenzhen, Guangdong 518129 (CN)
(74) Representative: Huawei European IPR
(86) International application number: PCT/CN2024/122060
(87) International publication number: WO 2025/156690

(57) **Abstract**

This application relates to the field of semiconductor technologies, and provides a memory array, a fabrication method therefor, a memory, and an electronic device, to improve arrangement density of the memory array. The memory array includes a plurality of memory cells arranged in an arrayed manner, and each memory cell includes a capacitor and a transistor. The capacitor includes a first electrode, a dielectric layer, and a second electrode, the first electrode is disposed to surround the second electrode, and the dielectric layer is between the first electrode and the second electrode. The transistor is disposed on the capacitor, the transistor includes a channel layer, a gate dielectric layer, and a gate electrode layer, the gate electrode layer surrounds a side surface of the channel layer, and the gate dielectric layer is between the channel layer and the gate electrode layer. The channel layer is in contact with the second electrode, the channel layer includes a first surface in contact with the second electrode, the second electrode includes a second surface in contact with the channel layer, and a boundary of the first surface overlaps a boundary of the second surface. The memory array may be applied to the memory, to read and write data.

## Description

This application claims priority to Chinese Patent Application No. 202410110956.0, filed with the China National Intellectual Property Administration on January 25, 2024 and entitled "MEMORY ARRAY, FABRICATION METHOD THEREFOR, MEMORY, AND ELECTRONIC DEVICE", which is incorporated herein by reference in its entirety.

### TECHNICAL FIELD

This application relates to the field of semiconductor technologies, and in particular, to a memory array, a fabrication method therefor, a memory, and an electronic device.

### BACKGROUND

A dynamic random access memory (Dynamic Random Access Memory, DRAM) has become one of mainstream memories by virtue of its high speed, high density, and low latency.

Currently, size miniaturization of the DRAM has reached a bottleneck, and how to improve arrangement density of a memory array in the memory to implement size miniaturization of a device has become an urgent problem to be resolved in the field.

### SUMMARY

Embodiments of this application provide a memory array, a fabrication method therefor, a memory, and an electronic device, to improve arrangement density of the memory array.

To achieve the foregoing objectives, the following technical solutions are used in embodiments of this application.

According to a first aspect, a memory array is provided. The memory array includes a plurality of memory cells arranged in an arrayed manner, and each memory cell includes a capacitor and a transistor. The capacitor includes a first electrode, a dielectric layer, and a second electrode, the first electrode is disposed to surround the second electrode, and the dielectric layer is between the first electrode and the second electrode. The transistor is disposed on the capacitor, the transistor includes a channel layer, a gate dielectric layer, and a gate electrode layer, the gate electrode layer surrounds a side surface of the channel layer, and the gate dielectric layer is between the channel layer and the gate electrode layer. The channel layer is in contact with the second electrode, the channel layer includes a first surface in contact with the second electrode, the second electrode includes a second surface in contact with the channel layer, and a boundary of the first surface overlaps a boundary of the second surface.

According to the memory array provided in this embodiment of this application, the memory array includes the plurality of memory cells arranged in an arrayed manner, and in the capacitor of each memory cell, the first electrode is disposed to surround the second electrode, and the dielectric layer is between the first electrode and the second electrode, so that the capacitor has a "columnar capacitor structure". The transistor is disposed on the capacitor, the transistor includes the channel layer, the gate dielectric layer, and the gate electrode layer, and the gate electrode layer surrounds the side surface of the channel layer. This helps improve a control capability of the gate electrode layer on the channel layer, and increase an operation voltage window of the transistor. The gate dielectric layer is between the channel layer and the gate electrode layer, so that the transistor has a "vertical transistor structure".

The columnar capacitor structure has a smaller planar size than a planar capacitor structure, and the vertical transistor structure has a smaller planar size than a planar transistor structure. This helps reduce a planar size of the memory cell, and increase a quantity of memory cells disposed per unit area, thereby improving arrangement density of the memory array.

The channel layer of the transistor is in contact with the second electrode of the capacitor, the channel layer includes the first surface in contact with the second electrode, the second electrode includes the second surface in contact with the channel layer, and the boundary of the first surface coincides with the boundary of the second surface. In other words, positions and sizes of ends of the channel layer and the second electrode that are in contact with each other are the same, and the channel layer is aligned with the second electrode with high alignment precision, thereby ensuring a stable connection between the transistor and the capacitor, and helping improve the arrangement density of the memory array.

In some embodiments, the memory array further includes a plurality of word lines. The plurality of memory cells arranged in an arrayed manner include a plurality of rows and a plurality of columns, and gate electrode layers of a plurality of transistors of memory cells in one row are connected to form one word line. The word line includes a conductive connection layer between gate electrode layers of two adjacent transistors, and a surface that is of the conductive connection layer and that is away from the capacitor is recessed towards the capacitor, so that a cross-sectional area of the conductive connection layer is small, thereby reducing materials used for fabricating the word line.

Alternatively, the conductive connection layer fills a gap between the gate electrode layers of the two adjacent transistors, so that a cross-sectional area of the word line is large, thereby helping reduce resistance of the word line, thereby reducing a voltage drop of a voltage signal transmitted on the word line.

In some embodiments, the memory array further includes a plurality of bit lines, and each bit line is disposed on a side of the transistor away from the capacitor. Each bit line is electrically connected to channel layers of a plurality of transistors of the memory cells in one column, and an end that is of the channel layer and that is connected to the bit line is a source electrode of the transistor.

In some embodiments, the memory array further includes a plate line disposed on a side that is of the capacitor and that is away from the transistor, and first electrodes of a plurality of capacitors in the plurality of memory cells are electrically connected to the plate line.

In some embodiments, the memory cell includes a plurality of capacitors and one transistor. In a direction from the capacitor to the transistor, the first electrodes of the plurality of capacitors are stacked and spaced apart, and second electrodes of the plurality of capacitors are connected to form a columnar electrode. The channel layer of the transistor is connected to one end of the columnar electrode.

In some embodiments, in the direction from the capacitor to the transistor, the memory array includes a plurality of stacked memory structures, and each memory structure includes a plurality of memory cells arranged in an arrayed manner. Three-dimensional stacking of the plurality of memory structures helps improve the arrangement density of the memory array.

In some embodiments, a material of the dielectric layer includes a ferroelectric material. In this case, the capacitor formed by the first electrode, the dielectric layer, and the second electrode is a ferroelectric capacitor.

According to a second aspect, a memory array fabrication method is provided. The fabrication method includes: forming an insulation layer with a plurality of vias on a substrate, where the plurality of vias are arranged in an arrayed manner; forming a first electrode, a dielectric layer, and a second electrode in the via, where the first electrode is on a surface of the via, the dielectric layer is on an interior side of the first electrode, and the second electrode is on an interior side of the dielectric layer; and for the substrate, a surface of a side that is of the second electrode and that is away from the substrate is lower than a surface of a side that is of the insulation layer and that is away from the substrate; forming a barrier layer in the via, where the barrier layer is on the interior side of the dielectric layer, and is on the side that is of the second electrode and that is away from the substrate; removing parts that are of the insulation layer, the first electrode, and the dielectric layer and that are on an exterior side of the barrier layer, to expose the barrier layer; and forming a gate dielectric layer and a gate electrode layer on a side surface of the barrier layer.

According to the fabrication method provided in this embodiment of this application, the insulation layer with the plurality of vias is formed on the substrate, and the first electrode, the dielectric layer, and the second electrode are formed in the via, where the first electrode is on the surface of the via, the dielectric layer and the second electrode are sequentially on the interior side of the first electrode, and the first electrode, the dielectric layer, and the second electrode form a "columnar capacitor structure". In addition, a top surface of the second electrode is lower than a top surface of the insulation layer, that is, a cavity is synchronously formed in the via in the process of fabricating the columnar capacitor structure.

Then, the barrier layer is formed in the cavity inside the via, where the barrier layer is also on the interior side of the dielectric layer, and the barrier layer is above the second electrode. Finally, the parts that are of the insulation layer, the first electrode, and the dielectric layer and that are on the exterior side of the barrier layer are removed, to expose the barrier layer, and the gate dielectric layer and the gate electrode layer are formed on the side surface of the barrier layer. The barrier layer may be used as a channel layer of the transistor, and the barrier layer, the gate dielectric layer, and the gate electrode layer form the transistor. Alternatively, the barrier layer may be used as a sacrificial layer, the barrier layer is replaced with a channel layer, and the channel layer, the gate dielectric layer, and the gate electrode layer form the transistor.

It can be seen that both the barrier layer and the second electrode are located on the interior side of the dielectric layer, and the barrier layer is located above the second electrode. Therefore, in a direction parallel to the substrate, positions and sizes of the barrier layer and the second electrode are defined by the same dielectric layer, that is, positions and sizes of the channel layer and the second electrode are defined by the same dielectric layer, so that the channel layer and the second electrode have the same position and the same size. In this way, the channel layer is "automatically aligned" with the second electrode.

In the exposure development process, a channel hole is etched on a gate electrode layer to form a channel layer, and the channel hole needs to be aligned with the second electrode. In contrast, in the foregoing fabrication method of this application, the exposure development process is not required in the process of "automatic alignment" between the channel layer and the second electrode. The fabrication process is simple and controllable, thereby helping reduce process difficulty and costs.

In some embodiments, forming the first electrode, the dielectric layer, and the second electrode in the via includes: forming the first electrode on the surface of the via; forming the dielectric layer on the interior side of the first electrode; depositing a conductive material to form a filling layer on the interior side of the dielectric layer; and removing a part that is of the filling layer and that is away from the substrate, to form a first cavity in the via, and form the second electrode by using a retained part of the filling layer. In this way, the first cavity is synchronously formed in the via in the process of fabricating the columnar capacitor structure.

Forming the barrier layer in the via includes forming the barrier layer in the first cavity. The barrier layer is in contact with the second electrode, the barrier layer and the second electrode have a same position, and sizes of ends of the barrier layer and the second electrode that are in contact with each other are the same.

In some embodiments, forming the gate dielectric layer and the gate electrode layer on the side surface of the barrier layer includes: forming a gate dielectric film and a gate electrode film on the exterior side of the barrier layer, where the gate dielectric film includes at least a first part on a side that is of the barrier layer and that is away from the substrate and a second part on the side surface of the barrier layer, and the gate electrode film includes at least a third part on the side that is of the barrier layer and that is away from the substrate and a fourth part on the side surface of the barrier layer; and removing the third part of the gate electrode film, and removing the first part of the gate dielectric film, where the retained second part is used as the gate dielectric layer, the fourth part is used as the gate electrode layer, and a surface of the side that is of the barrier layer and that is away from the substrate is exposed, so that a bit line is subsequently formed on the surface of the barrier layer, or the barrier layer is replaced with the channel layer.

In some embodiments, the plurality of vias include a plurality of rows and a plurality of columns, and a plurality of barrier layers in the plurality of vias include a plurality of rows and a plurality of columns. After forming the gate dielectric layer and the gate electrode layer on the side surface of the barrier layer, a first mask layer is formed. The first mask layer has a plurality of first openings, and each first opening exposes gate electrode layers on side surfaces of barrier layers in one row. A conductive material is deposited, to form a conductive connection layer between a plurality of barrier layers in a same row through the first opening, where the conductive connection layer is connected to gate electrode layers on side surfaces of the plurality of barrier layers to form a word line.

In some embodiments, the gate electrode film further includes a fifth part on a surface of the insulation layer, and the fifth part is connected to the gate electrode layers on the side surface of the plurality of barrier layers. After forming the gate dielectric layer and the gate electrode layer on the side surface of the barrier layer, a second mask layer is formed. The second mask layer has a plurality of second openings, and each second opening exposes an area between two adjacent rows of barrier layers. A part of the fifth part of the gate electrode film is removed through the second opening, where a retained part of the fifth part and gate electrode layers on side surfaces of barrier layers in a same row jointly form a word line.

In some embodiments, the barrier layer is directly used as the channel layer of the transistor, and the transistor includes the barrier layer, the gate dielectric layer, and the gate electrode layer. In this way, a bit line may be directly formed on the surface of the barrier layer, thereby simplifying process steps of fabricating the channel layer.

In some embodiments, the barrier layer is used as a sacrificial layer, and after forming the gate dielectric layer and the gate electrode layer on the side surface of the barrier layer, the barrier layer is removed to form a second cavity; and the channel layer of the transistor is formed in the second cavity. The transistor includes the channel layer, the gate dielectric layer, and the gate electrode layer. In this way, the barrier layer is replaced with the channel layer, and a process of pre-forming the channel layer is avoided. In a process of forming the gate dielectric layer and the gate electrode layer, etching damage to the channel layer is avoided, thereby helping improve film layer quality of the channel layer and improve electrical performance of the transistor.

According to a third aspect, a memory is provided. The memory includes the memory array in any one of the foregoing embodiments, and a controller electrically connected to the memory array.

According to a fourth aspect, an electronic device is provided. The electronic device is, for example, a consumer electronic product, a home electronic product, a vehicle-mounted electronic product, a financial terminal product, or a communication electronic product. The electronic device includes a circuit board and the memory in the foregoing embodiments, and the memory is electrically connected to the circuit board.

It may be understood that, for beneficial effect that can be achieved by the memory and the electronic device provided in the foregoing embodiments of this application, reference may be made to the beneficial effect of the memory array in the foregoing descriptions. Details are not described herein.

### BRIEF DESCRIPTION OF DRAWINGS

To describe technical solutions in this application more clearly, the following briefly describes accompanying drawings for describing some embodiments of this application. It is clear that the accompanying drawings in the following descriptions are merely accompanying drawings in some embodiments of this application. A person of ordinary skill in the art may further derive other drawings from these accompanying drawings. In addition, the accompanying drawings in the following descriptions may be considered as diagrams, and are not intended to limit an actual size of a product, an actual procedure of a method, and the like in embodiments of this application.
FIG. 1 is a diagram of an architecture of an electronic device according to an embodiment of this application;
FIG. 2 is an exploded diagram of an electronic device according to an embodiment of this application;
FIG. 3 is a diagram of an architecture of a memory according to an embodiment of this application;
FIG. 4 is a circuit diagram of a memory array according to an embodiment of this application;
FIG. 5A and FIG. 5B are flowcharts of fabricating a memory array according to an embodiment of this application;
FIG. 6A(a) to FIG. 6S(c) are diagrams of structures corresponding to steps of a memory array fabrication method according to an embodiment of this application;
FIG. 7A(a) to FIG. 7D(c) are diagrams of structures corresponding to steps of another memory array fabrication method according to an embodiment of this application;
FIG. 8A to FIG. 8F(c) are diagrams of structures corresponding to steps of still another memory array fabrication method according to an embodiment of this application;
FIG. 9 is a sectional view of a memory array along a plane X-Z according to an embodiment of this application;
FIG. 10 is a sectional view of a memory array along a plane Y-Z according to an embodiment of this application; and
FIG. 11 is a diagram of a structure of another memory array according to an embodiment of this application.

### DESCRIPTION OF EMBODIMENTS

The following clearly and completely describes technical solutions in some embodiments of this application with reference to the accompanying drawings. It is clear that the described embodiments are merely a part rather than all of embodiments of this application. All other embodiments obtained by a person of ordinary skill in the art based on embodiments of this application shall fall within the protection scope of this application.

Some embodiments of this application provide an electronic device. The electronic device may be different types of user equipment or terminal devices such as a mobile phone, a tablet computer, a personal digital assistant (Personal Digital Assistant, PDA), a television, or an intelligent wearable product (for example, a smartwatch or a smart band), a virtual reality (Virtual Reality, VR) terminal device, an augmented reality (Augmented Reality, AR) terminal device, a small-sized charging household appliance (for example, a soy milk maker or a robotic vacuum cleaner), an uncrewed aerial vehicle, a radar, an aerospace device, and a vehicle-mounted device. The electronic device may alternatively be a network device like a base station. The specific form of the electronic device is not specifically limited in embodiments of this application.

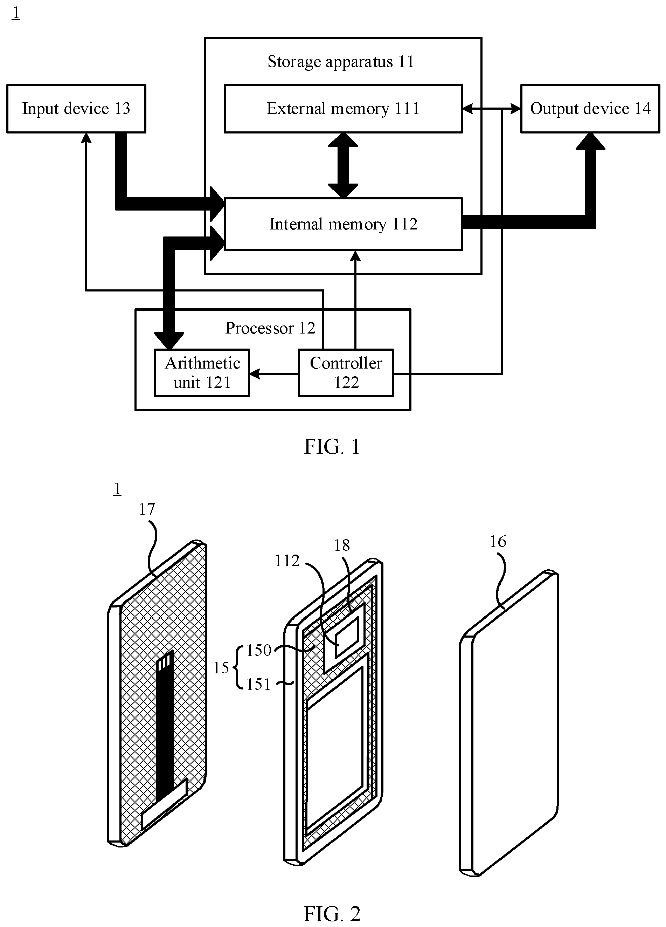

FIG. 1 is a diagram of an architecture of an electronic device according to an embodiment of this application.

Refer to FIG. 1. The electronic device 1 includes components such as a storage apparatus 11, a processor 12, an input device 13, and an output device 14. A person skilled in the art may understand that an architecture of the electronic device 1 shown in FIG. 1 does not constitute a limitation on the electronic device 1. The electronic device 1 may include more or fewer components than those shown in FIG. 1, or may combine some of the components shown in FIG. 1. Alternatively, component arrangement may be different from that shown in FIG. 1.

The storage apparatus 11 is configured to store a software program and a module. The storage apparatus 11 mainly includes a program storage area and a data storage area. The program storage area may store and back up an operating system, an application required by at least one function (such as a sound play function or an image play function), and the like. The data storage area may store data (such as audio data, image data, and a phone book) created based on use of the electronic device 1, and the like. In addition, the storage apparatus 11 includes an external memory 111 and an internal memory 112. Data stored in the external memory 111 and the internal memory 112 may be transmitted to each other.

The external memory 111 may include, for example, a hard disk, a USB flash drive, and a floppy disk. The internal memory 112 may include, for example, a dynamic random access memory (Dynamic Random Access Memory, DRAM), a static random access memory (Static Random Access Memory, SRAM), a resistive random access memory (Resistive Random Access Memory, RRAM), a phase change random access memory (Phase Change Random Access Memory, PCRAM), a ferroelectric random access memory (Ferroelectric Random Access Memory, FeRAM), a ferroelectric field-effect transistor (Ferroelectric Field-Effect Transistor, FeFET) memory, a ferroelectric tunnel junction (Ferroelectric Tunnel Junction, FTJ) memory, and a NAND flash (NAND Flash).

The processor 12 is a control center of the electronic device 1; is connected to various parts of the entire electronic device 1 through various interfaces and lines; and executes various functions of the electronic device 1 and/or processes data by running or executing a software program and/or a module stored in the storage apparatus 11 and invoking data stored in the storage apparatus 11. Optionally, the processor 12 may include one or more processing units. For example, the processor 12 may include an application processor (Application Processor, AP), a modem processor, and a graphics processing unit (Graphics Processing Unit, GPU). Different processing units may be independent components, or may be integrated into one or more processors. For example, the processor 12 may integrate the application processor and the modem processor. The application processor mainly processes an operating system, a user interface, an application, and the like. The modem processor mainly processes wireless communication. It may be understood that the modem processor may not be integrated into the processor 12. The application processor may be, for example, a central processing unit (Central Processing Unit, CPU). In FIG. 1, an example in which the processor 12 is a CPU is used. The CPU may include an arithmetic unit 121 and a controller 122. The arithmetic unit 121 obtains data stored in the internal memory 112, processes the data stored in the internal memory 112, and usually sends a processing result back to the internal memory 112. The controller 122 may control the arithmetic unit 121 to process the data, and the controller 122 may further control the external memory 111 and the internal memory 112 to read or write the data.

The input device 13 is configured to receive input digit or character information, and generate key signal input related to user setting and function control of the electronic device. For example, the input device 13 may include a touchscreen and another input device. The touchscreen, also referred to as a touch panel, may collect a touch operation performed by a user on the touchscreen or near the touchscreen (for example, an operation performed by the user on the touchscreen or near the touchscreen by using any suitable object or accessory such as a finger or a stylus), and drive a corresponding connection apparatus based on a preset program. The controller 122 in the processor 12 may further control the input device 13 to receive an input signal or not to receive an input signal. In addition, the input digit or character information received by the input device 13 and the key signal input related to the user setting and function control of the electronic device may be stored in the internal memory 112.

The output device 14 is configured to output a signal corresponding to data that is input by the input device 13 and stored in the internal memory 112. For example, the output device 14 outputs a sound signal or a video signal. The controller 122 in the processor 12 may further control the output device 14 to output a signal or not to output a signal.

It should be noted that a bold arrow in FIG. 1 indicates data transmission, and a direction of the bold arrow indicates a data transmission direction. For example, a unidirectional arrow between the input device 13 and the internal memory 112 indicates that data received by the input device 13 is transmitted to the internal memory 112. For another example, a bidirectional arrow between the arithmetic unit 121 and the internal memory 112 indicates that the data stored in the internal memory 112 may be transmitted to the arithmetic unit 121, and data processed by the arithmetic unit 121 may be transmitted to the internal memory 112. A thin arrow in FIG. 1 indicates a component that can be controlled by the controller 122. For example, the controller 122 may control the external memory 111, the internal memory 112, the arithmetic unit 121, the input device 13, the output device 14, and the like.

FIG. 2 is an exploded diagram of an electronic device according to an embodiment of this application.

Refer to FIG. 2. An example in which an electronic device 1 is a mobile phone is used. The electronic device 1 includes a middle frame 15, a rear housing 16, and a display screen 17. The rear housing 16 and the display screen 17 are respectively on two opposite sides of the middle frame 15. The middle frame 15 includes a bearing plate 150 and a frame 151 encircling the bearing plate 150. The bearing plate 150 is configured to bear the display screen 17.

Still refer to FIG. 2. The electronic device 1 may further include a circuit board 18. The circuit board 18 is disposed on a side that is of the bearing plate 150 and that is close to the rear housing 16. An internal memory 112 in the electronic device 1 may be disposed on the circuit board 18. The internal memory 112 is electrically connected to the circuit board 18.

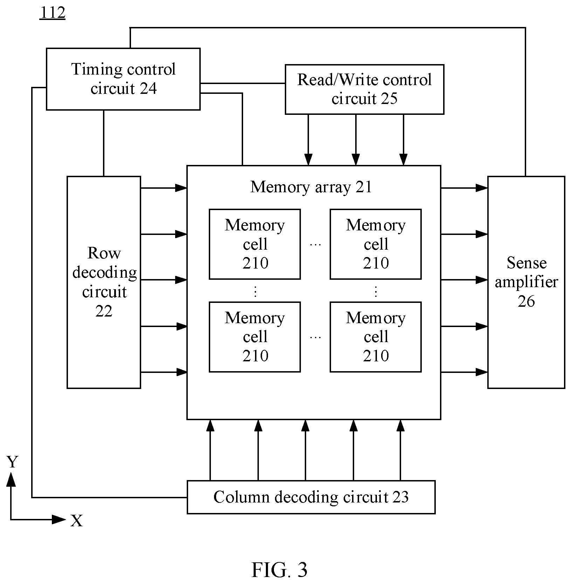

Currently, a DRAM is one of mainstream memories, and may be used as the internal memory 112. FIG. 3 is a diagram of an architecture of a memory according to an embodiment of this application.

Refer to FIG. 3. The internal memory 112 includes a memory array 21, a row decoding circuit 22, a column decoding circuit 23, a timing control circuit 24, a read/write control circuit 25, and a sense amplifier 26.

The memory array 21 includes a plurality of memory cells 210 arranged in an arrayed manner, and the plurality of memory cells 210 include a plurality of rows arranged in a first direction X and a plurality of columns arranged in a second direction Y. The first direction X and the second direction Y intersect each other, for example, the first direction X and the second direction Y are perpendicular to each other.

The timing control circuit 24 is electrically connected to the row decoding circuit 22, the column decoding circuit 23, the memory array 21, the read/write control circuit 25, and the sense amplifier 26 separately. The timing control circuit 24 is configured to perform timing control on each circuit.

The row decoding circuit 22 is electrically connected to the memory array 21, and the row decoding circuit 22 is configured to perform gating on memory cells 210 in a corresponding row based on a row address, to select a site for the memory cells 210 in the corresponding row.

The column decoding circuit 23 is electrically connected to the memory array 21. After gating is performed on the memory cells 210 in the corresponding row, the column decoding circuit 23 is configured to perform site selection on memory cells 210 in a corresponding column based on a column address, to select a memory cell 210 on which a read operation or a write operation needs to be performed.

The read/write control circuit 25 is electrically connected to the memory array 21, and the read/write control circuit 25 is configured to control the selected memory cell 210 to perform the read operation or the write operation.

The sense amplifier 26 is electrically connected to the memory array 21, and the sense amplifier 26 is configured to read, amplify, and output data information stored in the selected memory cell 210, to implement the data read operation; or input a data signal to the selected memory cell 210, to implement the data write operation.

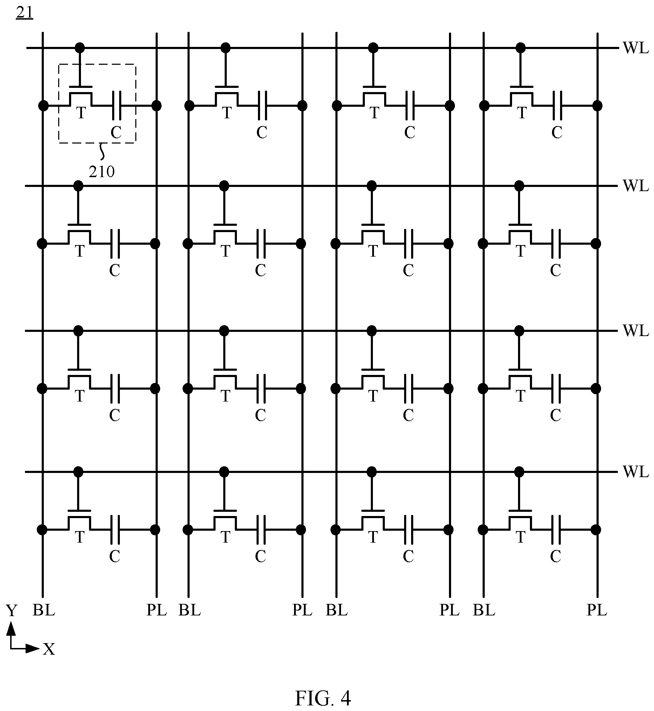

FIG. 4 is a circuit diagram of a memory array according to an embodiment of this application.

Refer to FIG. 4. The memory array 21 further includes a plurality of word lines (Word Lines, WLs) extending in a direction X, a plurality of bit lines (Bit Lines, BLs) extending in a direction Y, and a plurality of plate lines (Plate Lines, PLs) extending in the direction Y. Memory cells 210 in each row are electrically connected to one word line WL, and memory cells 210 in each column are electrically connected to one bit line BL and one plate line PL.

Still refer to FIG. 4. The memory cell 210 may have a 1T1C (1-Transistor-1-Capacitor) structure, that is, the memory cell 210 includes one transistor T and one capacitor C. A gate electrode of the transistor T is electrically connected to the word line WL, a source electrode is electrically connected to the bit line BL, a drain electrode is electrically connected to one electrode of the capacitor C, and the other electrode of the capacitor C is electrically connected to the plate line PL. A circuit architecture of memory cells 210 in this embodiment of this application is not limited thereto.

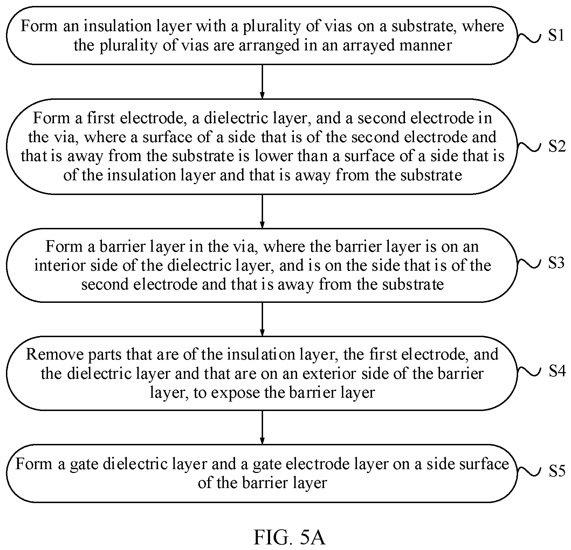

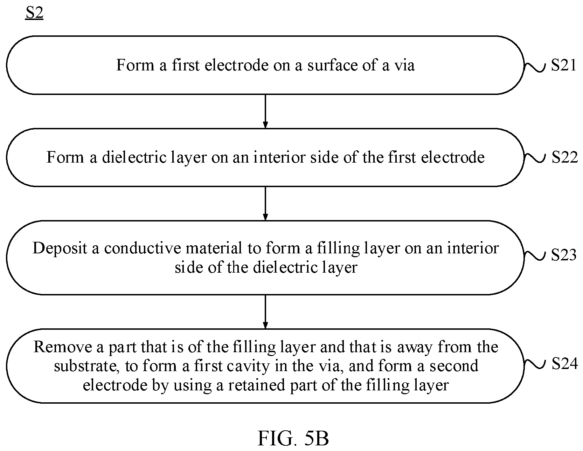

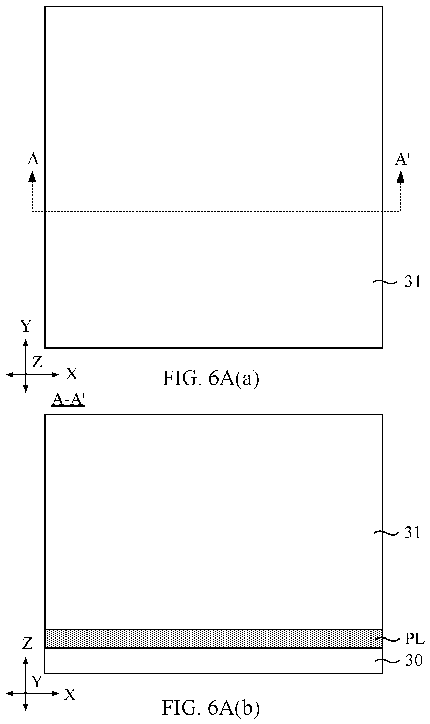

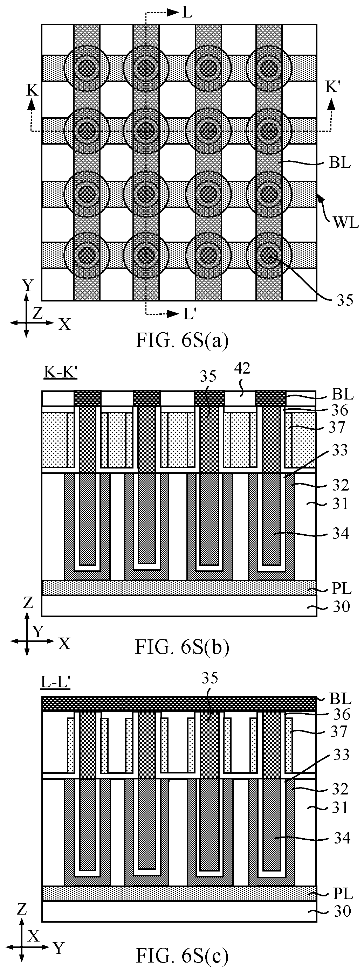

An embodiment of this application provides a memory array fabrication method. FIG. 5A and FIG. 5B are flowcharts of fabricating a memory array according to an embodiment of this application. FIG. 6A(a) to FIG. 6S(c) are diagrams of structures corresponding to steps of a memory array fabrication method according to an embodiment of this application.

Refer to FIG. 5A. The memory array fabrication method includes the following S1 to S5.

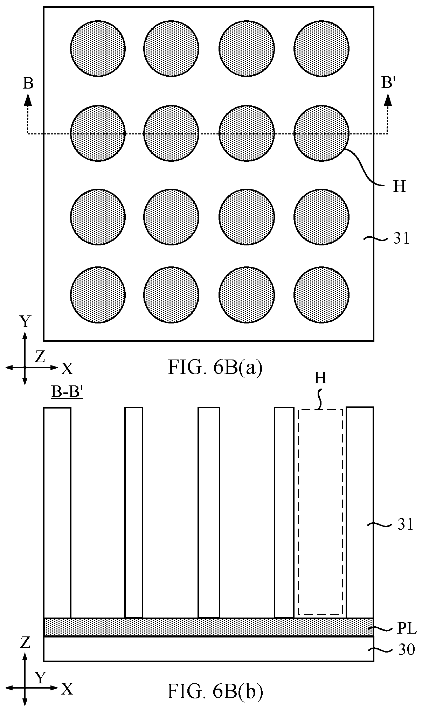

FIG. 6A(b) is a sectional view of FIG. 6A(a) along a sectional line A-A'; and FIG. 6B(b) is a sectional view of FIG. 6B(a) along a sectional line B-B'.

S1: As shown in FIG. 6A(a), FIG. 6A(b), FIG. 6B(a), and FIG. 6B(b), form a first insulation layer 31 with a plurality of vias H on a substrate 30, where the plurality of vias H are arranged in an arrayed manner. For example, the plurality of vias H include a plurality of rows and a plurality of columns, and the vias H in each row are arranged in a direction X, and the vias H in each column are arranged in a direction Y.

For example, as shown in FIG. 6A(a) and FIG. 6A(b), a plate line PL is first formed on the substrate 30, and the first insulation layer 31 is formed above the plate line PL. Then, as shown in FIG. 6B(a) and FIG. 6B(b), the first insulation layer 31 is etched by using a photoetching process, to form a plurality of vias H on the first insulation layer 31, where a bottom of the via H exposes the plate line PL.

For example, the plurality of vias H arranged in an arrayed manner include a plurality of rows and a plurality of columns, and the vias H in each row are arranged in a direction X, and the vias H in each column are arranged in a direction Y.

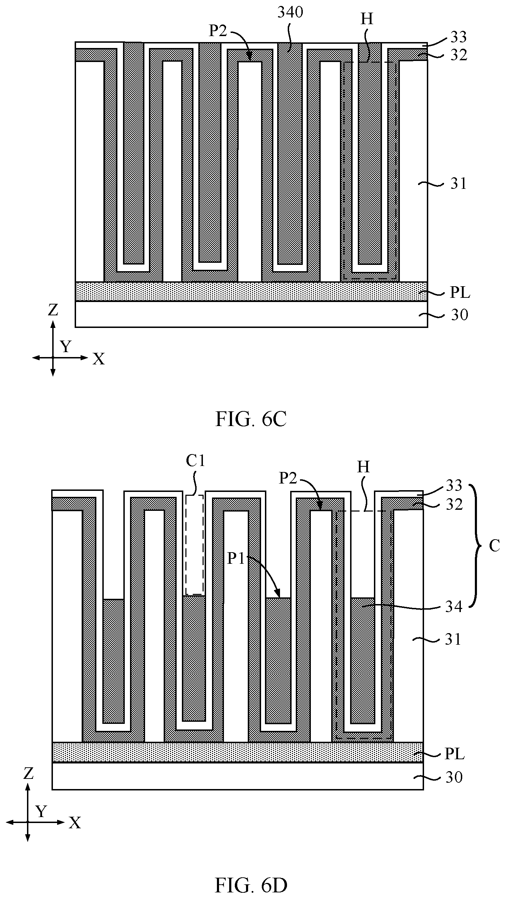

S2: As shown in FIG. 6C and FIG. 6D, form a first electrode 32, a dielectric layer 33, and a second electrode 34 in the via H, where the first electrode 32 is on a surface of the via H, the dielectric layer 33 is on an interior side of the first electrode 32, the second electrode 34 is on an interior side of the dielectric layer 33, the first electrode 32, the dielectric layer 33, and the second electrode 34 form a capacitor C, and the second electrode 34 is surrounded by the first electrode 32. The first electrode 32 may be referred to as a "bottom electrode", and the second electrode 34 may be referred to as a "top electrode", and the capacitor C has a "columnar capacitor structure".

Relative to the substrate 30, a surface P1 of a side that is of the second electrode 34 and that is away from the substrate 30 is lower than a surface P2 of a side that is of the first insulation layer 31 and that is away from the substrate 30, that is, relative to the substrate 30, a height of the surface P1 of the second electrode 34 is lower than a height of the surface P2 of the first insulation layer 31, to form a first cavity C1 in the via H.

In some examples, as shown in FIG. 5B, S2 may include the following S21 to S24.

S21: As shown in FIG. 6C, form the first electrode 32 on the surface of the via H, where the first electrode 32 is connected to the plate line PL at a bottom of the via H.

For example, an electrode material may be deposited on the entire surface, to form the first electrode 32, and the first electrode 32 may cover the surface of the via H, and may further cover the surface P2 on the side that is of the first insulation layer 31 and that is away from the substrate 30.

S22: As shown in FIG. 6C, form the dielectric layer 33 on the interior side of the first electrode 32.

For example, a dielectric material may be deposited on the entire surface, to form the dielectric layer 33. The dielectric layer 33 covers the first electrode 32, and the dielectric layer 33 is on the interior side of the first electrode 32 in the via H.

For example, a material of the dielectric layer 33 may include the dielectric material.

For example, a material of the dielectric layer 33 may include a ferroelectric material. In this case, the capacitor C formed by the first electrode 32, the dielectric layer 33, and the second electrode 34 is a ferroelectric capacitor.

S23: Still as shown in FIG. 6C, deposit a conductive material, to form a filling layer 340 on the interior side of the dielectric layer 33, to fill the via H.

S24: As shown in FIG. 6C and FIG. 6D, remove a part that is of the filling layer 340 and that is away from the substrate 30, to form the first cavity C1 in the via H, and form the second electrode 34 by using a retained part of the filling layer 340, so that the first cavity C1 is synchronously formed in the via H in the process of fabricating the capacitor C.

For example, a recess (recess) process may be used to downwardly etch the filling layer 340 to form the first cavity C1. The first cavity C1 is subsequently used to form a barrier layer (a channel layer of a transistor T). The first cavity C1 defines a size of the channel layer. In other words, an etching depth of the filling layer 340 depends on a height of the channel layer.

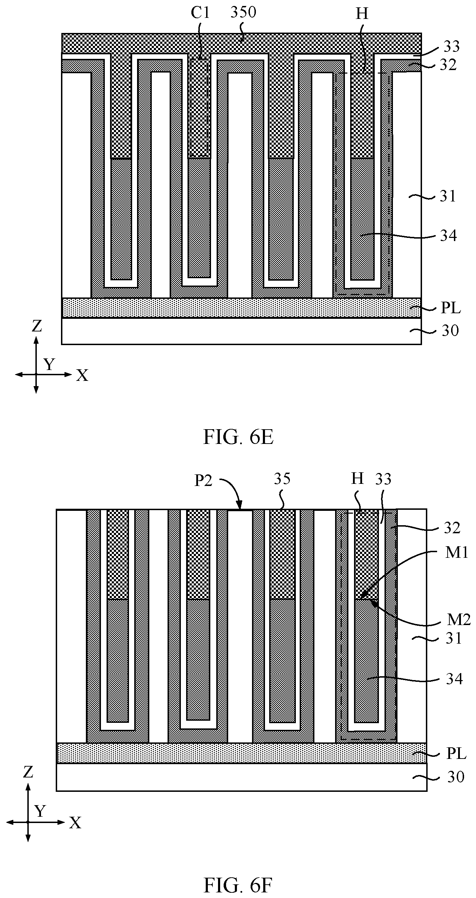

S3: As shown in FIG. 6E and FIG. 6F, form a barrier layer 35 in the via H, where the barrier layer 35 is on the interior side of the dielectric layer 33, and the barrier layer 35 is on the side that is of the second electrode 34 and that is away from the substrate 30.

It may be understood that the plurality of vias H include a plurality of rows and a plurality of columns, so that the plurality of barrier layers 35 in the plurality of vias H include a plurality of rows and a plurality of columns. The barrier layers 35 in each row are arranged in the direction X, and the barrier layers 35 in each column are arranged in the direction Y.

For example, as shown in FIG. 6E and FIG. 6F, a sacrificial material or a channel material may be deposited on the entire surface, to form a barrier film 350 in the first cavity C1. Then, a chemical mechanical polishing (Chemical Mechanical Polishing, CMP) process is used to polish an upper surface of the barrier film 350 until the surface P2 of the first insulation layer 31, the first electrode 32, and the dielectric layer 33 are exposed, and a retained part of the barrier film 350 forms the barrier layer 35.

Still as shown in FIG. 6F, the barrier layer 35 is in contact with the second electrode 34, the barrier layer 35 includes a first surface M1 in contact with the second electrode 34, the second electrode 34 includes a second surface M2 in contact with the barrier layer 35, and a boundary of the first surface M1 overlaps a boundary of the second surface M2, that is, sizes of end parts that are of the barrier layer 35 and the second electrode 34 and that are in contact with each other are the same.

It may be understood that, in the same via H, the barrier layer 35 is on the interior side of the dielectric layer 33, the second electrode 34 is also on the interior side of the dielectric layer 33, and the barrier layer 35 is above the second electrode 34. On a plane X-Y, locations and sizes of the barrier layer 35 and the second electrode 34 are limited by the dielectric layer 33 in the same via H, so that the barrier layer 35 and the second electrode 34 have a same position and a same size. In this way, the barrier layer 35 is "automatically aligned" with the second electrode 34.

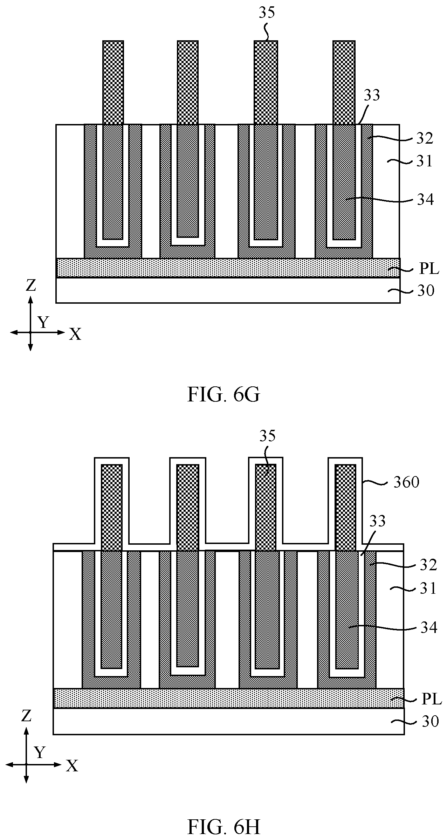

S4: As shown in FIG. 6F and FIG. 6G, remove a part that is of the first insulation layer 31 and that is on an exterior side of the barrier layer 35, remove a part that is of the first electrode 32 and that is on the exterior side of the barrier layer 35, and remove a part that is of the dielectric layer 33 and that is on the exterior side of the barrier layer 35, to expose the barrier layer 35.

For example, the first insulation layer 31 is first etched, and a part that is of the first insulation layer 31 and that is on the exterior side of the barrier layer 35 is removed, to expose a part that is of the first electrode 32 and that is on the exterior side of the barrier layer 35. Then, the first electrode 32 is etched, and a part that is of the first electrode 32 and that is on the exterior side of the barrier layer 35 is removed, to expose a part that is of the dielectric layer 33 and that is on the exterior side of the barrier layer 35. Finally, the dielectric layer 33 is etched, and a part that is of the dielectric layer 33 and that is on the exterior side of the barrier layer 35 is removed, to expose a side surface of the barrier layer 35.

It may be understood that a material of the barrier layer 35 has a high etch selectivity ratio to materials of the first insulation layer 31, the first electrode 32, and the dielectric layer 33. Therefore, in the processes of etching the first insulation layer 31, the first electrode 32, and the dielectric layer 33, no etching damage is caused to the barrier layer 35, to retain the barrier layer 35.

S5: As shown in FIG. 6H to FIG. 6L, form a gate dielectric layer 36 and a gate electrode layer 37 on the side surface of the barrier layer 35.

For example, as shown in FIG. 6H, an atomic layer deposition (Atomic Layer Deposition) process is used to deposit a gate dielectric material on the entire surface, and a gate dielectric film 360 is formed on the exterior side of the barrier layer 35.

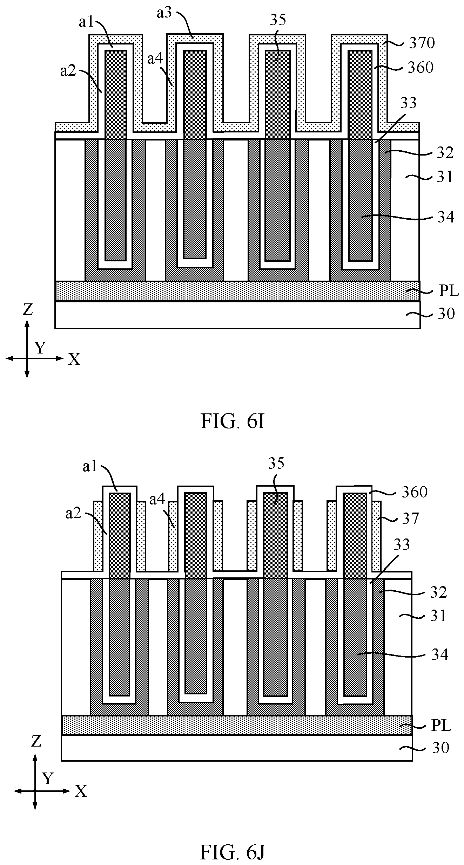

Refer to FIG. 6I. A conductive material is deposited on the entire surface, and a gate electrode film 370 is formed on a surface of the gate dielectric film 360, where the gate dielectric film 360 includes a first part a1 on a side that is of the barrier layer 35 and that is away from the substrate 30, and a second part a2 on the side surface of the barrier layer 35. The gate electrode film 370 includes a third part a3 on a side that is of the barrier layer 35 and that is away from the substrate 30, and a fourth part a4 on the side surface of the barrier layer 35.

Refer to FIG. 6I and FIG. 6J. The third part a3 of the gate electrode film 370 is removed, the fourth part a4 of the gate electrode film 370 forms the gate electrode layer 37, and the gate electrode layer 37 surrounds the side surface of the barrier layer 35. After the channel layer of the transistor T is subsequently formed, a control capability of the gate electrode layer 37 on the channel layer is improved, and an operating voltage window of the transistor T is increased.

For example, a dry etching process may be used to downwardly etch the gate electrode film 370. In the process of removing the third part a3 of the gate electrode film 370, a part that is of the gate electrode film 370 and that is on the surface of the first insulation layer 31 is also removed, so that the gate electrode layers 37 on side surfaces of the plurality of barrier layers 35 are disconnected from each other.

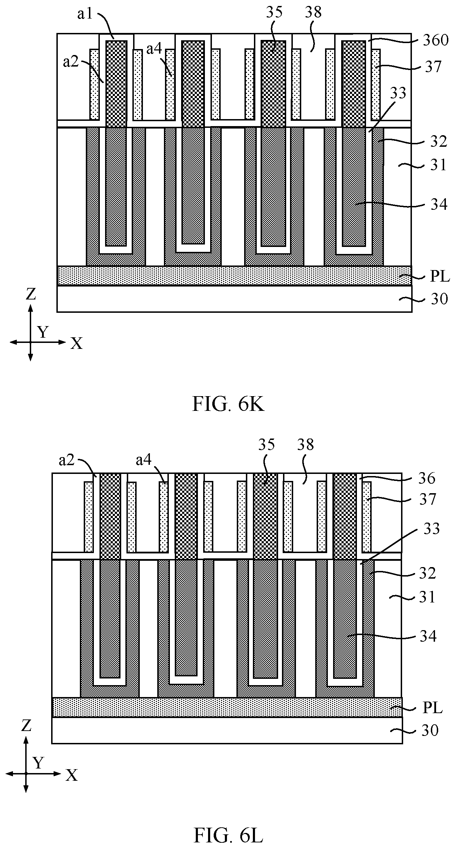

Refer to FIG. 6K. A dielectric material is deposited on the entire surface, and a second insulation layer 38 is formed on exterior sides of the barrier layers 35. The second insulation layer 38 is used for filling, to facilitate subsequent polishing.

Refer to FIG. 6K and FIG. 6L. A chemical mechanical polishing process is used to polish an upper surface of the second insulation layer 38 and the first part a1 of the gate dielectric film 360, and remove the first part a1 of the gate dielectric film 360, to expose a surface of the side that is of the barrier layer 35 and that is away from the substrate 30. The second part a2 of the gate dielectric film 360 is used as the gate dielectric layer 36. In addition, a retained part of the second insulation layer 38 covers the gate electrode layer 37.

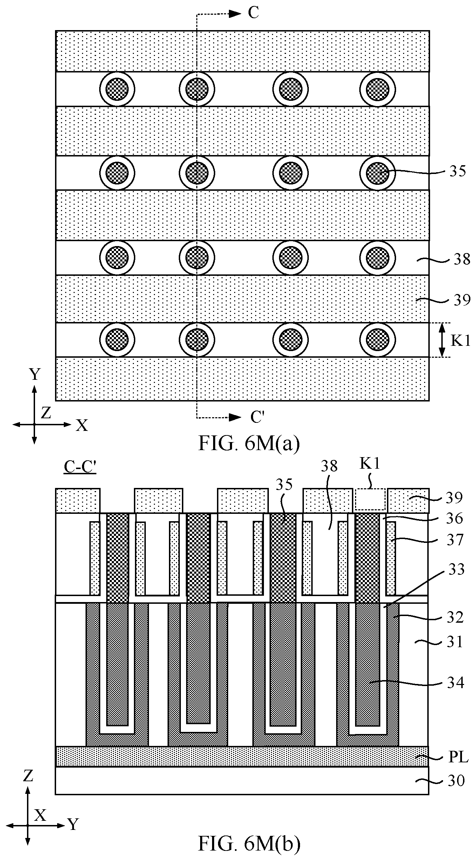

FIG. 6M(b) is a sectional view of FIG. 6M(a) along a sectional line C-C'.

After S5, as shown in FIG. 6M(a) and FIG. 6M(b), a first mask layer 39 is formed on the second insulation layer 38. For example, the first mask layer 39 may be photoresist, and exposure development may be performed on the first mask layer 39, to form a plurality of first openings K1 on the first mask layer 39. Each first opening K1 extends in the direction X, each first opening K1 exposes barrier layers 35 in one row in the direction X, and exposes a part that is of the second insulation layer 38 and that is between a plurality of barrier layers 35 in the same row.

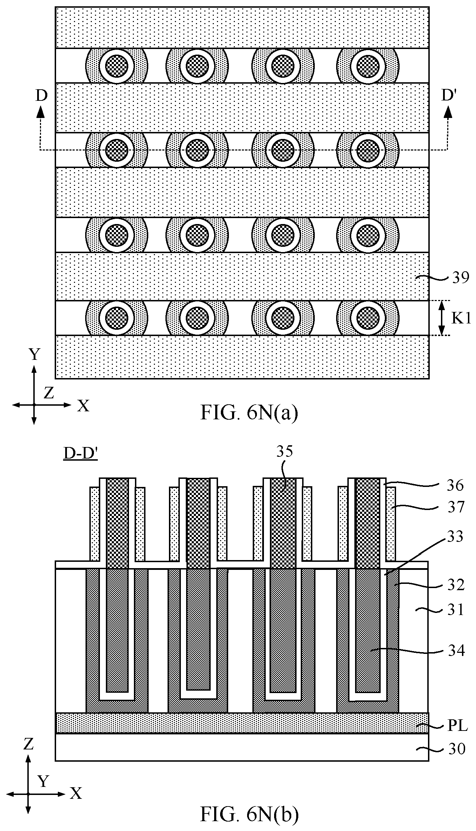

FIG. 6N(b) is a sectional view of FIG. 6N(a) along a sectional line D-D'.

Refer to FIG. 6M(a), FIG. 6M(b), FIG. 6N(a), and FIG. 6N(b). The part that is of the second insulation layer 38 and that is between the plurality of barrier layers 35 in the same row is etched through the first opening K1 of the first mask layer 39, and the part that is of the second insulation layer 38 and that is between the plurality of barrier layers 35 in the same row is removed, so that each first opening K1 exposes gate electrode layers 37 on side surfaces of barrier layers 35 in one row.

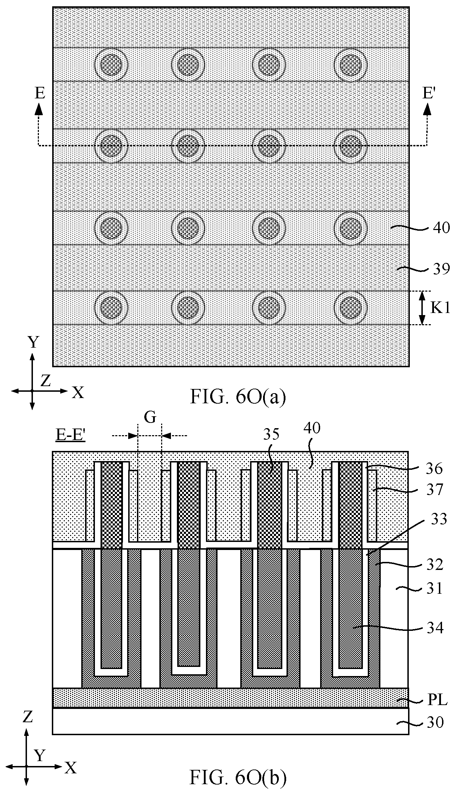

FIG. 6O(b) is a sectional view of FIG. 6O(a) along a sectional line E-E'.

Refer to FIG. 6O(a) and FIG. 6O(b). A conductive material is deposited on the entire surface, and the conductive material fills a gap G between a plurality of barrier layers 35 in a same row through the first opening K1 of the first mask layer 39, to form a conductive connection layer 40. The conductive connection layer 40 is connected to the gate electrode layers 37 on the side surfaces of the plurality of barrier layers 35.

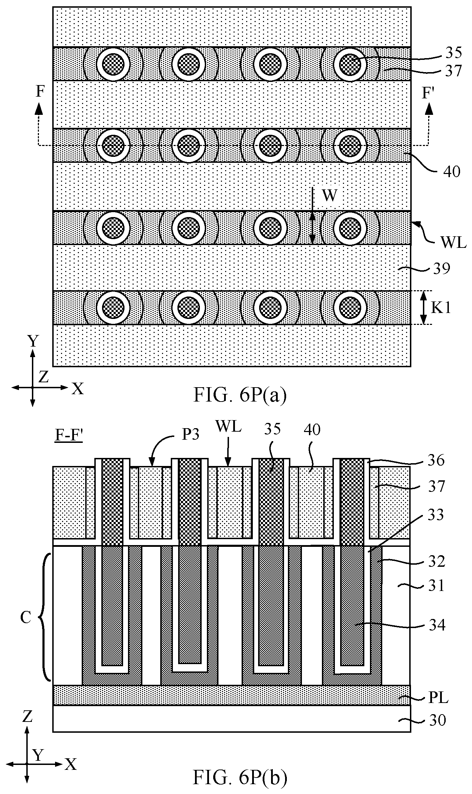

FIG. 6P(b) is a sectional view of FIG. 6P(a) along a sectional line F-F'.

Refer to FIG. 6P(a) and FIG. 6P(b). A back etching process is used to downwardly etch the conductive connection layer 40, and a part that of the conductive connection layer 40 and that fills between two adjacent barrier layers 35 is retained. The conductive connection layer 40 is connected in series to gate electrode layers 37 on side surfaces of barrier layers 35 in a same row, to form a word line WL extending in the direction X. A width W of the word line WL depends on a width of the first opening K1. In the direction Y, the width of the first opening K1 may be greater than a size of the barrier layer 35, may be equal to the size of the barrier layer 35, or may be less than the size of the barrier layer 35, so that the width W of the word line WL may be greater than, equal to, or less than the size of the barrier layer 35.

Because the conductive connection layer 40 fills the gap G between the plurality of barrier layers 35, a surface P3 of the word line WL that is away from the capacitor C is flush, and a cross-sectional area of the word line WL in the Y direction is large. This helps reduce resistance of the word line WL, thereby reducing a voltage drop of a voltage signal transmitted on the word line WL.

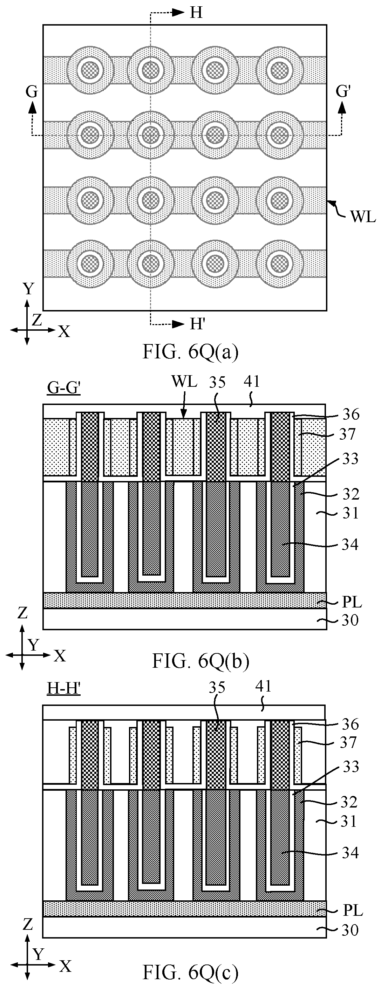

FIG. 6Q(b) is a sectional view of FIG. 6Q(a) along a sectional line G-G', and FIG. 6Q(c) is a sectional view of FIG. 6Q(a) along a sectional line H-H'.

Refer to FIG. 6Q(a) to FIG. 6Q(c). A dielectric material is deposited on the entire surface to form a third insulation layer 41, and the third insulation layer 41 covers a plurality of word lines WL.

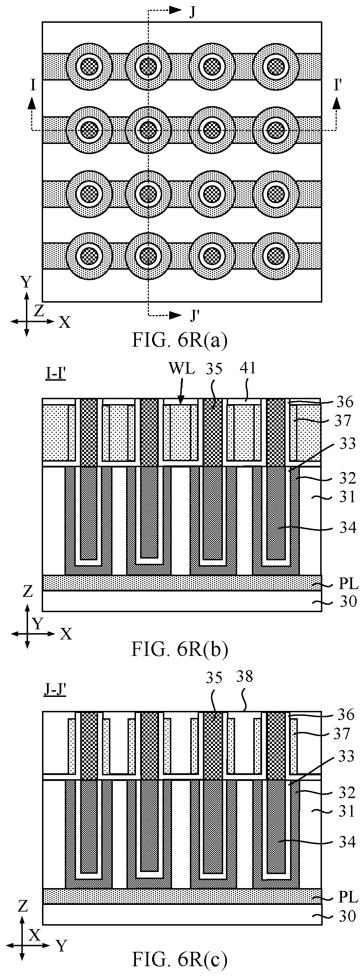

FIG. 6R(b) is a sectional view of FIG. 6R(a) along a sectional line I-I', and FIG. 6R(c) is a sectional view ofFIG. 6R(a) along a sectional line J-J'.

Refer to FIG. 6Q(a) to FIG. 6Q(c) and FIG. 6R(a) to FIG. 6R(c). An upper surface of the third insulation layer 41 is polished by using a chemical mechanical polishing process, until an upper surface of the barrier layer 35 is exposed.

FIG. 6S(b) is a sectional view of FIG. 6S(a) along a sectional line K-K', and FIG. 6S(c) is a sectional view ofFIG. 6S(a) along a sectional line L-L'.

Refer to FIG. 6S(a) to FIG. 6S(c). A plurality of bit lines BL are formed, each bit line BL extends in the direction Y, and each bit line BL is connected to barrier layers 35 in a same column.

For example, a dielectric material is first deposited on the entire surface to form a fourth insulation layer 42. Then, an exposure development process is used to etch the fourth insulation layer 42 to form a via, and the via exposes the barrier layer 35. Finally, a bit line BL is formed in the via of the fourth insulation layer 42.

It may be understood that, if a proper channel material is selected as the material of the barrier layer 35, the barrier layer 35 may be directly used as the channel layer of the transistor T, thereby simplifying process steps of fabricating the channel layer.

The transistor T includes the barrier layer 35, the gate dielectric layer 36, and the gate electrode layer 37. The barrier layer 35 is a vertical channel structure extending in a direction Z. The gate electrode layer 37 is on the side surface of the barrier layer 35. The gate dielectric layer 36 is between the barrier layer 35 and the gate electrode layer 37. The transistor T has a "vertical transistor structure".

The gate electrode layer 37 is used as a gate electrode of the transistor T, and the gate electrode layer 37 belongs to a part of the word line WL, that is, the gate electrode of the transistor T is electrically connected to the word line WL. An end that is of the barrier layer 35 and that is connected to the bit line BL is a source electrode of the transistor T. The barrier layer 35 is connected to the second electrode 34, and an end that is of the barrier layer 35 and that is connected to the second electrode 34 is a drain electrode of the transistor T. The transistor T is connected to the capacitor C to form a memory cell 210.

According to the foregoing description, the barrier layer 35 and the second electrode 34 have a same position and a same size, and the barrier layer 35 and the second electrode 34 are "automatically aligned". Because the barrier layer 35 may be directly used as a channel layer of the transistor T, the channel layer and the second electrode 34 have the same position and the same size. In this way, the channel layer is "automatically aligned" with the second electrode 34, and alignment precision between the channel layer and the second electrode 34 is high, thereby ensuring a stable connection between the transistor T and the capacitor C.

In the exposure development process, a channel hole is etched on a gate electrode layer to form a channel layer, and the channel hole needs to be aligned with the second electrode. In contrast, in the foregoing fabrication method of this application, the capacitor C has the columnar capacitor structure, and the columnar capacitor structure occupies a smaller area on the plane X-Y than a planar capacitor structure; the transistor T has the vertical transistor structure, and the vertical transistor structure occupies a smaller area on the plane X-Y than a planar transistor structure, thereby helping reduce an area occupied by the memory cell 210 on the plane X-Y; and the channel layer of the transistor T is "automatically aligned" with the second electrode 34 with high precision, thereby helping increase a quantity of memory cells 210 disposed per unit area on the plane X-Y, and improve arrangement density of the memory array 21, to achieve a 4F2 unit size of the memory array 21. "F" is a minimum feature size (Feature Size) of a chip manufacturing process, and the "4F2 unit size" means a square of twice the minimum feature size (4F2=2F×2F).

In addition, the exposure development process is not required in the process of "automatic alignment" between the channel layer and the second electrode 34. The exposure development process is used only twice in the process of fabricating the word line WL and the bit line BL. The fabrication process is simple and controllable, thereby helping reduce process difficulty and costs.

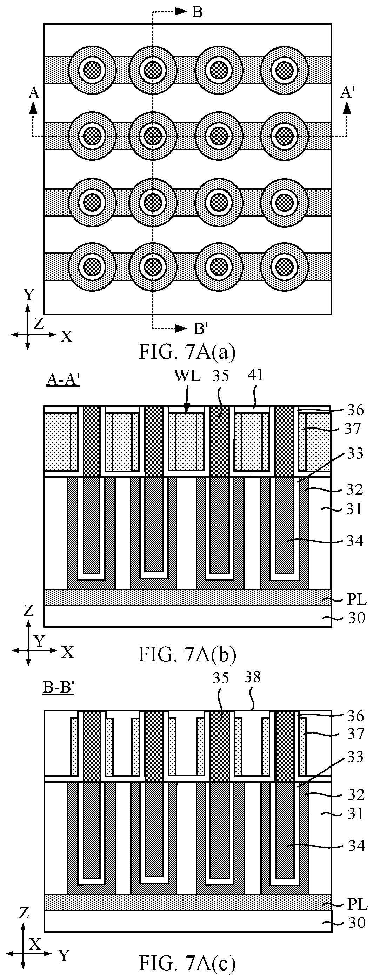

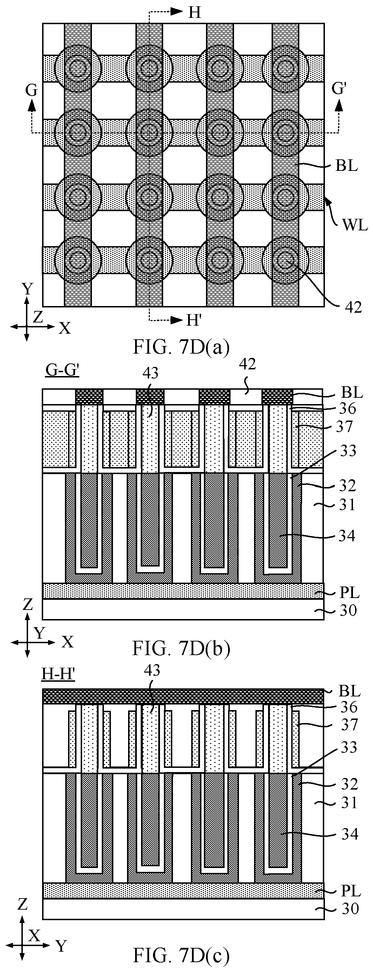

An embodiment of this application further provides another memory array fabrication method. FIG. 7A(a) to FIG. 7D(c) are diagrams of structures corresponding to steps of another memory array fabrication method according to an embodiment of this application.

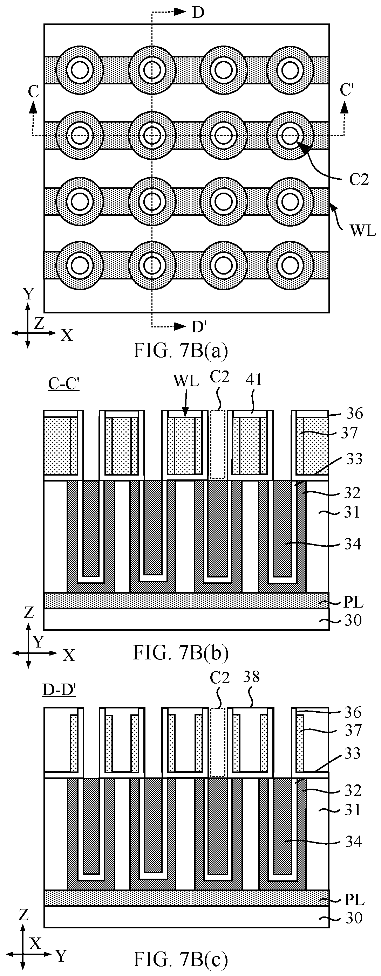

FIG. 7A(b) is a sectional view of FIG. 7A(a) along a sectional line A-A'; and FIG. 7A(c) is a sectional view of FIG. 7A(a) along a sectional line B-B'. FIG. 7B(b) is a sectional view of FIG. 7B(a) along a sectional line C-C'; and FIG. 7B(c) is a sectional view of FIG. 7B(a) along a sectional line D-D'.

Refer to FIG. 7A(a) to FIG. 7A(c), the fabrication steps in FIG. 6A(a) to FIG. 6R(c) in the foregoing fabrication method may be used to form a structure in FIG. 7A(a) to FIG. 7A(c), and an upper surface of a barrier layer 35 is exposed.

Unlike the fabrication method shown in FIG. 6A(a) to FIG. 6S(c), in the fabrication method in this embodiment, a material of the barrier layer 35 is not a material that can be used as a channel layer, but a sacrificial material. For example, the material of the barrier layer 35 may include silicon nitride. Therefore, as shown in FIG. 7A(a) to FIG. 7A(c) and FIG. 7B(a) to FIG. 7B(c), the barrier layer 35 is used as a sacrificial layer, and the barrier layer 35 is removed to form a second cavity C2. The second cavity C2 exposes a second electrode 34 below the second cavity C2.

It may be understood that the material of the barrier layer 35 has a high etch selectivity ratio to materials of a second insulation layer 38 and a third insulation layer 41. Therefore, in the process of etching the barrier layer 35, no etching damage is caused to the second insulation layer 38 and the third insulation layer 41.

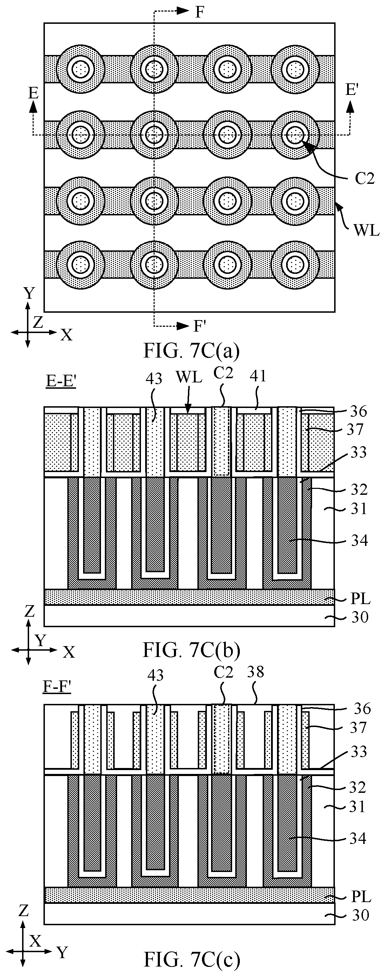

FIG. 7C(b) is a sectional view of FIG. 7C(a) along a sectional line E-E', and FIG. 7C(c) is a sectional view of FIG. 7C(a) along a sectional line F-F'.

Refer to FIG. 7C(a) to FIG. 7C(c). A channel layer 43 of a transistor T is formed in the second cavity C2, the channel layer 43 is connected to the second electrode 34, and the channel layer 43, a gate dielectric layer 36, and a gate electrode layer 37 form the transistor T.

FIG. 7D(b) is a sectional view of FIG. 7D(a) along a sectional line G-G', and FIG. 7D(c) is a sectional view of FIG. 7D(a) along a sectional line H-H'.

Refer to FIG. 7D(a) to FIG. 7D(c). A plurality of bit lines BL are formed, each bit line BL extends in a direction Y, and each bit line BL is connected to channel layers 43 in a same column.

It may be understood that film layer quality of the channel layer 43 affects electrical performance of the transistor T. Better film layer quality of the channel layer 43 indicates better electrical performance of the transistor T.

After the gate dielectric layer 36 and the gate electrode layer 37 are formed on a side surface of the barrier layer 35 by using the barrier layer 35 as the sacrificial layer, the barrier layer 35 is removed to form the second cavity C2, and the channel layer 43 is formed in the second cavity C2. In this way, the barrier layer 35 is replaced with the channel layer 43, to avoid forming of the channel layer 43 in advance and etching damage to the channel layer 43 in the process of forming the gate dielectric layer 36 and the gate electrode layer 37, thereby helping improve film layer quality of the channel layer 43 and improve electrical performance of the transistor T.

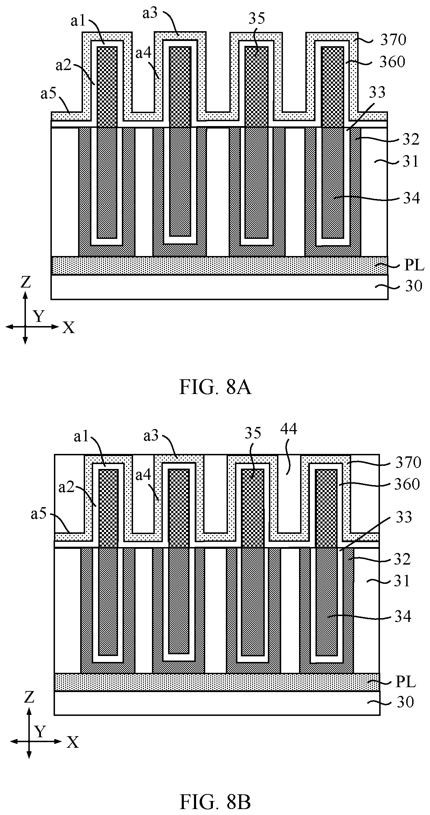

An embodiment of this application further provides still another memory array fabrication method. FIG. 8A to FIG. 8F(c) are diagrams of structures corresponding to steps of still another memory array fabrication method according to an embodiment of this application. Unlike the fabrication method shown in FIG. 6A(a) to FIG. 6S(c), this embodiment provides another method for fabricating a word line WL.

Refer to FIG. 8A, the fabrication steps in FIG. 6A(a) to FIG. 6I in the foregoing fabrication method may be used to form a structure in FIG. 8A, and a gate dielectric film 360 and a gate electrode film 370 are formed on an exterior side of a barrier layer 35. The gate dielectric film 360 includes a first part a1 on a side that is of the barrier layer 35 and that is away from a substrate 30, and a second part a2 on a side surface of the barrier layer 35. The gate electrode film 370 includes a third part a3 on a side that is of the barrier layer 35 and that is away from the substrate 30, a fourth part a4 on the side surface of the barrier layer 35, and a fifth part a5 on a surface of a first insulation layer 31, where the fifth part a5 is connected to the fourth part a4.

Refer to FIG. 8B. A dielectric material is deposited on an entire surface to form a fifth insulation layer 44 covering the gate electrode film 370. The fifth insulation layer 44 is used for filling, to facilitate subsequent polishing.

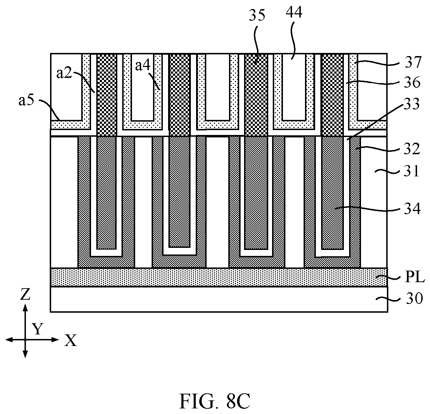

Refer to FIG. 8B and FIG. 8C. A chemical mechanical polishing process is used to polish an upper surface of the fifth insulation layer 44, the third part a3 of the gate electrode film 370, and the first part a1 of the gate dielectric film 360, and remove the third part a3 of the gate electrode film 370 and the first part a1 of the gate dielectric film 360, to expose an upper surface of the barrier layer 35. The fourth part a4 of the gate electrode film 370 is used as the gate electrode layer 37, and the second part a2 of the gate dielectric film 360 is used as the gate dielectric layer 36.

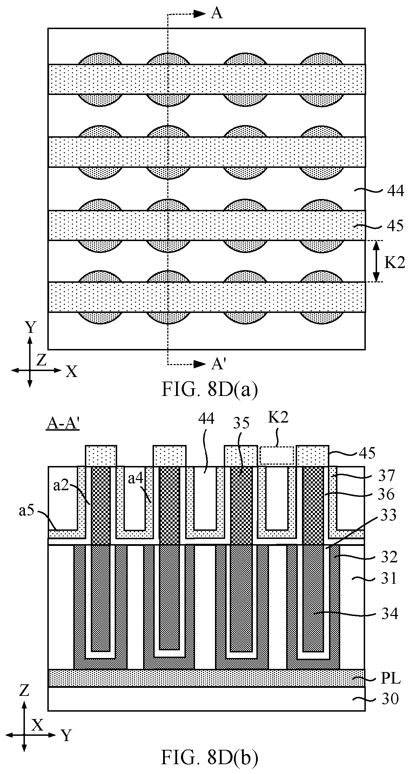

FIG. 8D(b) is a sectional view of FIG. 8D(a) along a sectional line A-A'.

Refer to FIG. 8D(a) and FIG. 8D(b). A second mask layer 45 is formed. For example, the second mask layer 45 may be photoresist, and exposure development may be performed on the second mask layer 45, to form a plurality of second openings K2 on the second mask layer 45. Each second opening K2 extends in a direction X, and each second opening K2 exposes an area (the fifth insulation layer 44) between two adjacent rows of barrier layers 35.

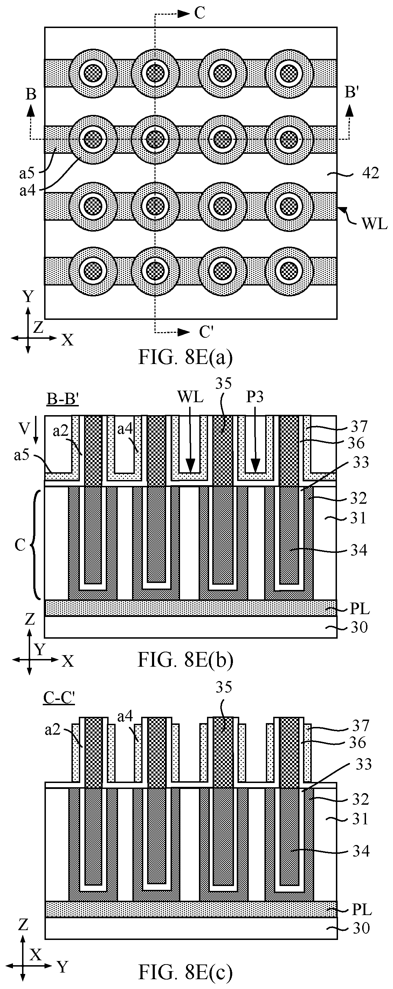

FIG. 8E(b) is a sectional view of FIG. 8E(a) along a sectional line B-B', and FIG. 8E(c) is a sectional view of FIG. 8E(a) along a sectional line C-C'.

Refer to FIG. 8D(a), FIG. 8D(b), and FIG. 8E(a) to FIG. 8E(c). The fifth insulation layer 44 is etched through the second opening K2 of the second mask layer 45, to expose the fourth part a4 and the fifth part a5 of the gate electrode film 370. Then, the fifth part a5 of the gate electrode film 370 is etched through the second opening K2 of the second mask layer 45, and a part of the fifth part a5 of the gate electrode film 370 is removed, so that the gate electrode film 370 is disconnected in a direction Y. Parts that are of the fifth part a5 and that are retained are used as conductive connection layers to form a plurality of word lines WL extending in the direction X with the fourth part a4 (gate electrode layers 37 on side surfaces of barrier layers 35 in a same row). A surface P3 that is of the fifth part a5 and that is away from the capacitor C is recessed towards the capacitor C in a direction V, so that a cross-sectional area of the word line WL in the Y direction is small, thereby reducing materials used for fabricating the word line.

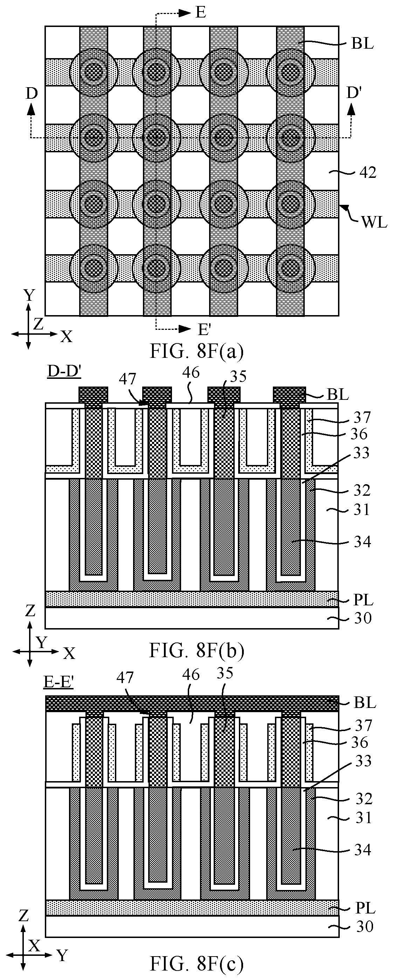

FIG. 8F(b) is a sectional view of FIG. 8F(a) along a sectional line D-D', and FIG. 8F(c) is a sectional view of FIG. 8F(a) along a sectional line E-E'.

Refer to FIG. 8F(a) to FIG. 8F(c). A dielectric material is first deposited on the entire surface to form a sixth insulation layer 46 covering the barrier layer 35 and the gate electrode layer 37. Then, a plurality of vias 47 are formed on the sixth insulation layer 46, and the vias 47 expose the upper surface of the barrier layer 35. Finally, a plurality of bit lines BL are formed, each bit line BL extends in the direction Y, and each bit line BL is connected to barrier layers 35 in a same column.

According to the fabrication methods provided in the foregoing embodiments of this application, the gate electrode film 370 is polished by using a chemical mechanical polishing process to form the gate electrode layer 37, and the gate electrode layer 37 is disconnected in the direction Y through etching, to form the plurality of word lines WL. This simplifies a fabrication process of the word lines WL, and helps reduce process costs.

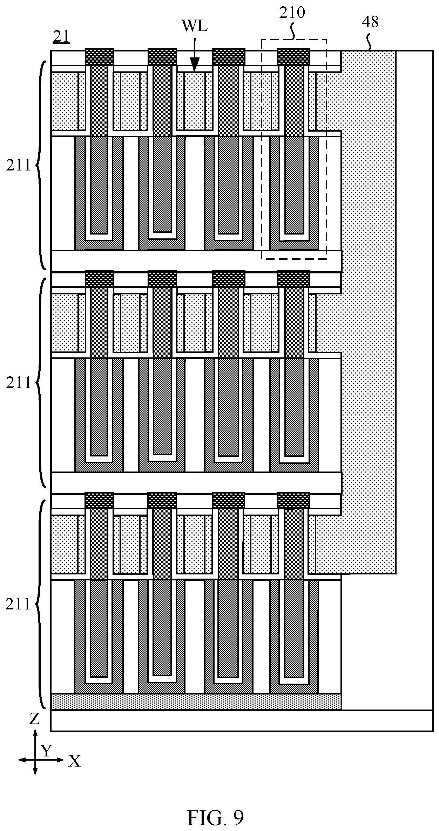

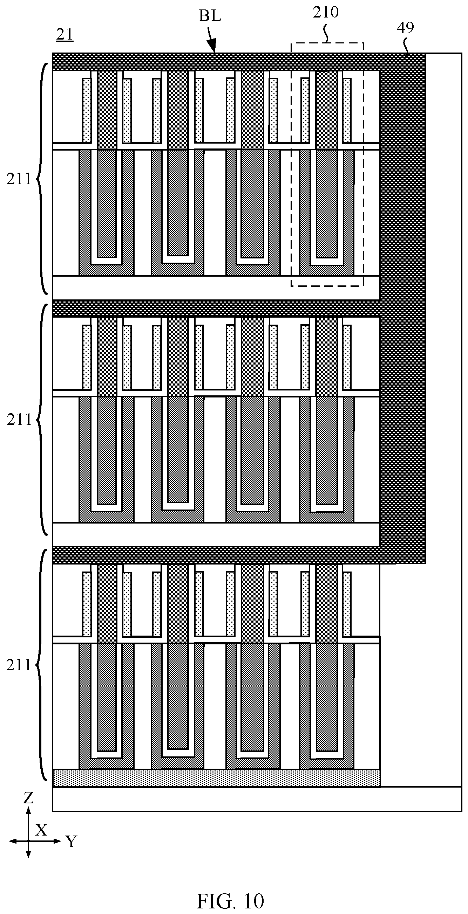

An embodiment of this application further provides a memory array. FIG. 9 is a sectional view of a memory array along a plane X-Z according to an embodiment of this application. FIG. 10 is a sectional view of the memory array along a plane Y-Z according to the embodiment of this application.

Refer to FIG. 9 and FIG. 10. In a direction Z, the memory array 21 includes a plurality of stacked memory structures 211, and any one or more of the plurality of memory structures 211 may be fabricated by using the fabrication methods described above.

The memory array 21 is a three-dimensional memory array. Each memory structure 211 includes a plurality of memory cells 210 arranged in an arrayed manner. Three-dimensional stacking of the memory cells 210 helps increase a quantity of memory cells 210 disposed per unit area on the plane X-Y, and improve arrangement density of the memory array 21.

For example, as shown in FIG. 9, the memory array 21 further includes a word line connection structure 48, and the word line connection structure 48 penetrates the plurality of stacked memory structures 211. In the direction Z, a plurality of word lines WL in the plurality of memory structures 211 correspond to each other, and the plurality of corresponding word lines WL are connected through the word line connection structure 48.

Similarly, as shown in FIG. 10, the memory array 21 further includes a bit line connection structure 49, and the bit line connection structure 49 penetrates the plurality of stacked memory structures 211. In the direction Z, a plurality of bit lines BL in the plurality of memory structures 211 correspond to each other, and the plurality of corresponding bit lines BL are connected through the bit line connection structure 49.

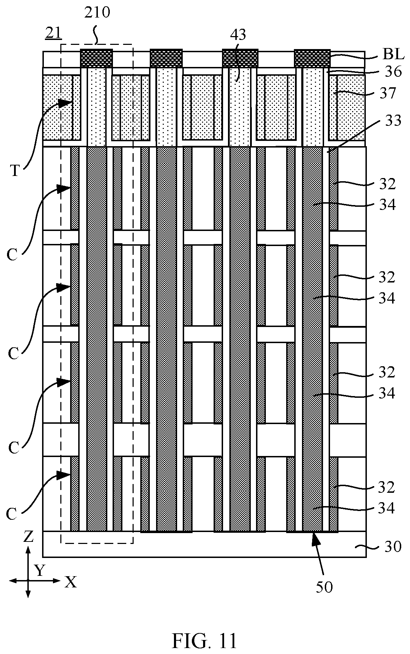

An embodiment of this application further provides a memory array. FIG. 11 is a diagram of a structure of another memory array according to an embodiment of this application.

Refer to FIG. 11. The memory array 21 includes a plurality of memory cells 210 arranged in an arrayed manner. The memory cell 210 may have a 1TnC (1-Transistor-n-Capacitor) structure, where n is an integer greater than 1. In other words, the memory cell 210 includes one transistor T and a plurality of capacitors C.

In a direction Z, first electrodes 32 of the plurality of capacitors C are stacked and spaced apart, a second electrode 34 of each capacitor C penetrates the first electrode 32 of the capacitor C, and the second electrodes 34 of the plurality of capacitors C are connected. For example, the second electrodes 34 of the plurality of capacitors C are integrated to form a columnar electrode 50. A channel layer 43 of the transistor T is connected to the second electrodes 34 of the plurality of capacitors C (a top end of the columnar electrodes 50).

It may be understood that the memory array 21 may also be fabricated by using the foregoing fabrication methods. On a plane X-Y, positions and sizes of the channel layer 43 and the columnar electrode 50 are limited by a same dielectric layer 33, so that the channel layer 43 and the columnar electrode 50 have a same position and a same size. In this way, the channel layer 43 is "automatically aligned" with the columnar electrode 50.

The foregoing descriptions are merely specific implementations of the present invention, and are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A memory array, wherein the memory array comprises a plurality of memory cells arranged in an arrayed manner, and the memory cell comprises a capacitor and a transistor;
the capacitor comprises a first electrode, a dielectric layer, and a second electrode, the first electrode is disposed to surround the second electrode, and the dielectric layer is between the first electrode and the second electrode;
the transistor is disposed on the capacitor, the transistor comprises a channel layer, a gate dielectric layer, and a gate electrode layer, the gate electrode layer surrounds a side surface of the channel layer, and the gate dielectric layer is between the channel layer and the gate electrode layer; and
the channel layer is in contact with the second electrode, the channel layer comprises a first surface in contact with the second electrode, the second electrode comprises a second surface in contact with the channel layer, and a boundary of the first surface overlaps a boundary of the second surface.

2. The memory array according to claim 1, wherein the memory array further comprises a plurality of word lines;
the plurality of memory cells arranged in an arrayed manner comprise a plurality of rows and a plurality of columns, and gate electrode layers of a plurality of transistors of memory cells in one row are connected to form one word line; and
the word line comprises a conductive connection layer between gate electrode layers of two adjacent transistors, and a surface that is of the conductive connection layer and that is away from the capacitor is recessed towards the capacitor, or the conductive connection layer fills a gap between the gate electrode layers of the two adjacent transistors.

3. The memory array according to claim 1 or 2, wherein the memory array further comprises a plurality of bit lines, and the bit line is disposed on a side that is of the transistor and that is away from the capacitor; and
the plurality of memory cells arranged in an arrayed manner comprise the plurality of rows and the plurality of columns, and each bit line is electrically connected to channel layers of a plurality of transistors of memory cells in one column.

4. The memory array according to any one of claims 1 to 3, wherein the memory array further comprises a plate line, and the plate line is disposed on a side that is of the capacitor and that is away from the transistor; and
first electrodes of a plurality of capacitors in the plurality of memory cells are electrically connected to the plate line.

5. The memory array according to any one of claims 1 to 4, wherein the memory cell comprises a plurality of capacitors and one transistor;
in a direction from the capacitor to the transistor, the first electrodes of the plurality of capacitors are stacked and spaced apart, and second electrodes of the plurality of capacitors are connected to form a columnar electrode; and
the channel layer of the transistor is connected to one end of the columnar electrode.

6. The memory array according to any one of claims 1 to 5, wherein in the direction from the capacitor to the transistor, the memory array comprises a plurality of stacked memory structures, and each memory structure comprises a plurality of memory cells arranged in an arrayed manner.

7. The memory array according to any one of claims 1 to 6, wherein a material of the dielectric layer comprises a ferroelectric material.

8. A memory array fabrication method, comprising:
forming an insulation layer with a plurality of vias on a substrate, wherein the plurality of vias are arranged in an arrayed manner;
forming a first electrode, a dielectric layer, and a second electrode in the via, wherein the first electrode is on a surface of the via, the dielectric layer is on an interior side of the first electrode, and the second electrode is on an interior side of the dielectric layer; and for the substrate, a surface of a side that is of the second electrode and that is away from the substrate is lower than a surface of a side that is of the insulation layer and that is away from the substrate;
forming a barrier layer in the via, wherein the barrier layer is on the interior side of the dielectric layer, and is on the side that is of the second electrode and that is away from the substrate;
removing a part that is of the insulation layer and that is on an exterior side of the barrier layer, removing a part that is of the first electrode and that is on the exterior side of the barrier layer, and removing a part that is of the dielectric layer and that is on the exterior side of the barrier layer, to expose the barrier layer; and
forming a gate dielectric layer and a gate electrode layer on a side surface of the barrier layer.

9. The fabrication method according to claim 8, wherein forming the first electrode, the dielectric layer, and the second electrode in the via comprises:
forming the first electrode on the surface of the via;
forming the dielectric layer on the interior side of the first electrode;
depositing a conductive material to form a filling layer on the interior side of the dielectric layer; and
removing a part that is of the filling layer and that is away from the substrate, to form a first cavity in the via, and form the second electrode by using a retained part of the filling layer; and
forming the barrier layer in the via comprises:
forming the barrier layer in the first cavity.

10. The fabrication method according to claim 8 or 9, wherein forming the gate dielectric layer and the gate electrode layer on the side surface of the barrier layer comprises:
forming a gate dielectric film and a gate electrode film on the exterior side of the barrier layer, wherein the gate dielectric film comprises at least a first part on a side that is of the barrier layer and that is away from the substrate and a second part on the side surface of the barrier layer, and the gate electrode film comprises at least a third part on the side that is of the barrier layer and that is away from the substrate and a fourth part on the side surface of the barrier layer; and
removing the third part of the gate electrode film, and removing the first part of the gate dielectric film, to expose a surface that is of the barrier layer and that is away from the substrate, wherein
the second part is used as the gate dielectric layer, and the fourth part is used as the gate electrode layer.

11. The fabrication method according to claim 10, wherein the plurality of vias comprise a plurality of rows and a plurality of columns, and a plurality of barrier layers in the plurality of vias comprise a plurality of rows and a plurality of columns; and
after forming the gate dielectric layer and the gate electrode layer on the side surface of the barrier layer, the fabrication method further comprises:
forming a first mask layer, wherein the first mask layer has a plurality of first openings, and each first opening exposes gate electrode layers on side surfaces of barrier layers in one row; and
depositing a conductive material, to form a conductive connection layer between a plurality of barrier layers in a same row through the first opening, wherein the conductive connection layer is connected to gate electrode layers on side surfaces of the plurality of barrier layers to form a word line.

12. The fabrication method according to claim 10, wherein the plurality of vias comprise a plurality of rows and a plurality of columns, and a plurality of barrier layers in the plurality of vias comprise a plurality of rows and a plurality of columns;
the gate electrode film further comprises a fifth part on a surface of the insulation layer, and the fifth part is connected to the gate electrode layers on the side surface of the plurality of barrier layers; and
after forming the gate dielectric layer and the gate electrode layer on the side surface of the barrier layer, the fabrication method further comprises:
forming a second mask layer, wherein the second mask layer has a plurality of second openings, and each second opening exposes an area between two adjacent rows of barrier layers; and
removing a part of the fifth part of the gate electrode film through the second opening, wherein a retained part of the fifth part and gate electrode layers on side surfaces of barrier layers in a same row jointly form a word line.

13. The fabrication method according to any one of claims 8 to 12, wherein the barrier layer is used as a channel layer of a transistor, and the transistor comprises the barrier layer, the gate dielectric layer, and the gate electrode layer.

14. The fabrication method according to any one of claims 8 to 12, wherein after the barrier layer is used as a sacrificial layer, and after forming the gate dielectric layer and the gate electrode layer on the side surface of the barrier layer, the fabrication method further comprises:
removing the barrier layer to form a second cavity; and
forming a channel layer of a transistor in the second cavity, wherein the transistor comprises the channel layer, the gate dielectric layer, and the gate electrode layer.

15. A memory, comprising:
the memory array according to any one of claims 1 to 7; and
a controller, wherein the memory array is electrically connected to the controller.

16. An electronic device, comprising:
the memory according to claim 15; and
a circuit board, wherein the memory is electrically connected to the circuit board.
